# EUROPEAN PATENT APPLICATION

(11) **EP 4 776 794 A1**
(43) Date of publication of application: **15.07.2026**
(21) Application number: 25188305.4
(22) Date of filing: 09.07.2025
(51) Int. Cl.: H10F 39/10, H10F 30/225, H10F 77/20, H10F 77/40

(54) **DOME-SHAPED LENS(ES) AND GUARD RING FOR SINGLE-PHOTON AVALANCHE DIODE PHOTODETECTOR AND RELATED METHOD**

(30) Priority: 08.01.2025 US 202519013086
(71) Applicant: GlobalFoundries Singapore Pte. Ltd., Singapore 738406 (SG)
(72) Inventor: Ng, Yong Chau, 738406 Singapore (SG); Gramuglia, Francesco, 81541 Munich (DE); Villalon, Anthony Jeremy, 738406 Singapore (SG); Kandasamy, Deepthi, 738406 Singapore (SG); Chow, Yew Tuck Clament, 738406 Singapore (SG); Tan, Li Fei, 738406 Singapore (SG); Toh, Eng Huat, 738406 Singapore (SG)
(74) Representative: Grünecker Patent- und Rechtsanwälte PartG mbB

(57) **Abstract**

A structure includes at least one single-photon avalanche diode (SPAD), at least one dome-shaped lens over each SPAD, and a metal guard ring surrounding each SPAD. A frontside illuminated SPAD photodetector and a method of forming the structure is also provided. The dome-shaped lens(es) with the metal guard ring improve SPAD efficiency in terms of photo detection probability (PDP) and light absorption with minimal increase in area.

## Description

### TECHNICAL FIELD

Embodiments of the disclosure relate generally to photodetection structures. More specifically, various embodiments of the disclosure provide a structure with a dome-shaped lens(es) and a guard ring for a single-photon avalanche diode (SPAD) photodetector, and related methods.

### BACKGROUND

Photodetectors convert optical power into electrical voltage or current. Photodetectors may be formed as an avalanche photodiode (APD). Thanks to its internal gain, an avalanche photodiode is much more sensitive to incoming light compared to other types of photodetectors, e.g., P-I-N photodiodes. Moreover, an APD typically provides a significant increase in the receiver signal-to-noise ratio (SNR). A single-photon avalanche diode photodetector (SPAD) is an APD that is electrically biased significantly above its reverse-bias breakdown voltage, increasing sensitivity to light to the single-photon level. In microelectronic circuits, SPAD sensitivity, i.e., photo detection probability (PDP), may be limited by the ability to direct light (photons) efficiently to the active area of the SPAD using, for example, a single, planar microlens arrangement.

### SUMMARY

All aspects, examples and features mentioned below can be combined in any technically possible way.

An aspect of the disclosure provides a structure, comprising: at least one single-photon avalanche diode (SPAD) in a substrate; at least one dome-shaped lens over each SPAD; and a metal guard ring surrounding each SPAD.

An aspect of the disclosure provides a front-side illuminated single-photon avalanche diode (FSI SPAD) photodetector, comprising: at least one FSI SPAD in a substrate; at least one dome-shaped lens over each FSI SPAD; and a metal guard ring surrounding each FSI SPAD.

An aspect of the disclosure provides a method, comprising: forming at least one single-photon avalanche diode (SPAD) in a substrate; forming a metal guard ring surrounding each SPAD; and forming at least one dome-shaped lens over each SPAD.

Two or more aspects described in this disclosure, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The embodiments of this disclosure will be described in detail, with reference to the following figures, wherein like designations denote like elements, and wherein:
FIG. 1 shows a cross-sectional view of a structure including a single-photon avalanche diode (SPAD) with dome-shaped lenses and a metal guard ring according to embodiments of the disclosure;
FIG. 2 shows a cross-sectional view of a structure including a SPAD with a dome-shaped lens and a metal guard ring according to other embodiments of the disclosure;
FIGS. 3A-B show schematic top-down views of a structure along an illustrative view line A-A in FIG. 1 according to various embodiments of the disclosure;
FIG. 4 shows a partial top-down view of an arrangement of dome-shaped lenses according to embodiments of the disclosure;
FIG. 5 shows a partial top-down view of an arrangement of dome-shaped lenses according to other embodiments of the disclosure;
FIG. 6 shows a partial top-down view of an arrangement of dome-shaped lenses according to additional embodiments of the disclosure;
FIG. 7 shows a cross-sectional view of a metal guard ring according to embodiments of the disclosure;
FIG. 8 shows a cross-sectional view of a metal guard ring according to other embodiments of the disclosure;
FIG. 9 shows a schematic top-down view of a structure along an illustrative view line A-A in FIG. 1 according to other embodiments of the disclosure;
FIG. 10 shows a schematic top-down view of a structure along an illustrative view line A-A in FIG. 1 according to additional embodiments of the disclosure;
FIG. 11 shows a schematic top-down view of a structure along an illustrative view line B-B in FIG. 1 according to embodiments of the disclosure;
FIG. 12 shows a cross-sectional view of a structure including a SPAD with dome-shaped lenses and a metal guard ring according to yet other embodiments of the disclosure;
FIG. 13 shows a cross-sectional view of initial processes of forming a SPAD according to embodiments of the disclosure;
FIG. 14 shows a cross-sectional view of forming a metal guard ring according to embodiments of the disclosure;
FIGS. 15 and 16 show cross-sectional views of forming a mask for forming dome-shaped lens(es) according to embodiments of the disclosure; and
FIG. 17 shows a cross-sectional view of forming dome-shaped lens(es) according to embodiments of the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

In the following description, reference is made to the accompanying drawings that form a part thereof, and in which is shown by way of illustration specific illustrative embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

It will be understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (A) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed.

Embodiments of the disclosure includes a structure including at least one single-photon avalanche diode (SPAD), at least one dome-shaped lens over each SPAD, and a metal guard ring surrounding each SPAD. A front-side illuminated SPAD photodetector and a method of forming the structure are also provided. The dome-shaped lens(es) with the metal guard ring improve SPAD efficiency in terms of photo detection probability (PDP) and light absorption with minimal increase in areal size.

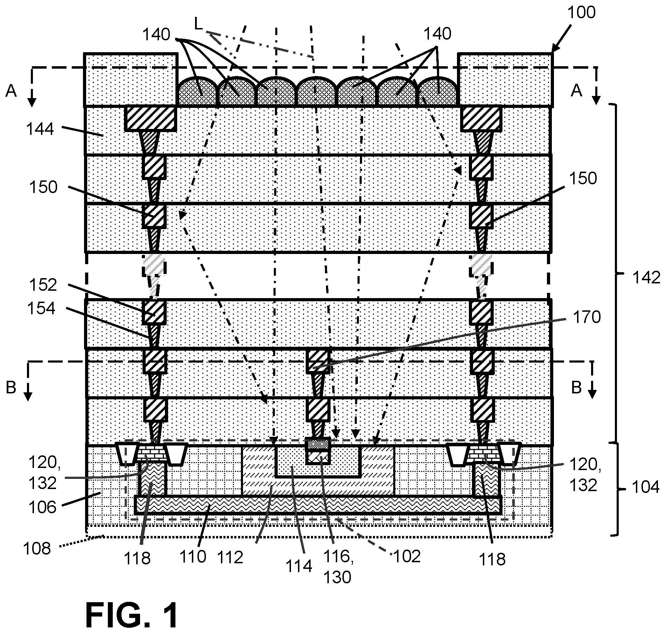

FIG. 1 shows a cross-sectional view of a structure 100 according to embodiments of the disclosure. Structure 100 according to the disclosure operates using diodes and, in particular, those capable of being a photodiode or photodetector. That is, diodes that convert light into electrical energy. Generally, a diode is a two-terminal element that behaves differently from conductive or insulative materials between two points of electrical contact. Specifically, a diode provides high conductivity from one contact to the other in one direction (i.e., the "forward" direction) but provides little to no conductivity in the opposite direction (i.e., the "reverse" direction). In the case of the P-N junction, the orientation of a diode's forward and reverse directions may be contingent on the type and magnitude of voltage applied to the material composition of one or both terminals, which affect the size of the potential barrier. In the case of a junction between two semiconductor materials, the potential barrier will form along the interface between the two semiconductor materials.

An "avalanche junction," also known as an "avalanche diode" or "avalanche photodiode" is a particular type of diode structure for bidirectional control of current flows through an integrated circuit (IC) structure. Avalanche photodiodes (APD) are capable of being photodetectors. Avalanche junctions are distinct from P-N diodes by featuring a much wider depletion region, i.e., the more lightly doped region of semiconductor material between the oppositely doped terminals of the diode. Applying an electrical voltage across the depletion region may accelerate minority charge carriers in the insulative material to an extent that creates ionization in a crystal lattice. In turn, the accelerated minority charge carriers produce more charge carriers and more electrical ionization. This effect is known as "avalanche breakdown."

Continuing with FIG. 1, structure 100 may include at least one single-photon avalanche diode (SPAD) 102 (see dashed box) in a substrate 104. As noted, a SPAD 102 is an avalanche photodiode (APD) that is electrically biased significantly above its reverse-bias breakdown voltage, increasing sensitivity to light, and allowing the photodiode to operate with less damage or noise than other APDs. SPADs may detect even single photons with high sensitivity.

Substrate 104 includes, for example, one or more semiconductor materials. Substrate 104 may be at least partially formed of any currently known or later developed semiconductor material, which may include without limitation: silicon, germanium, silicon germanium, and substances consisting essentially of one or more III-V compound semiconductors having a composition defined by the formula Al_{X1}Ga_{X2}In_{X3}As_{Y1}P_{Y2}N_{Y3}Sb_{Y4}, where X1, X2, X3, Y1, Y2, Y3, and Y4 represent relative proportions, each greater than or equal to zero and X1+X2+X3+Y1+Y2+Y3+Y4=1 (1 being the total relative mole quantity). Substrate 104 may be in the form of a bulk substrate, a semiconductor on insulator (SOI) substrate, and/or various other kinds of substrates. In the case of an SOI substrate, a semiconductor top layer 106 of the SOI substrate may be on a buried insulator layer 108 (shown in dashed lines) composed of any currently known or later developed insulator material, e.g., any one or more of various oxides, nitrides, and/or other insulator materials discussed herein.

Portions of substrate 104 may include dopants providing doped wells therein. In the art of semiconductor processing, a "well" refers to a portion of a substrate that contains a particular type and concentration of impurities (dopants) to control its conductivity. According to one example, semiconductor layer 106 of substrate 104 may have a low amount of P-type doping. When referring to dopants, P-type dopants refer to elements introduced into semiconductor material to generate free holes by "accepting" electrons from a semiconductor atom and consequently "releasing" the hole. The acceptor atom must have one valence electron less than the host semiconductor. P-type dopants may include but are not limited to: boron (B), indium (In) and gallium (Ga). Boron (B) is the most common acceptor in integrated circuit technology. In contrast, N-type dopants are introduced to semiconductor material to generate free electron (by "donating" electron to semiconductor). N-type dopants may include but are not limited to: phosphorous (P), arsenic (Ar), antimony (Sb), bismuth (Bi), and lithium (L). Phosphorous and arsenic are the most common examples of n-type doping in integrated circuit technology. As known in the art, doping type may be notated as either "p" or "n" followed by a "plus" or "minus" sign, in which minus denotes a lower concentration than a baseline concentration and plus (or two pluses) denotes a higher concentration than the baseline concentration.

SPAD 102 may include a number of wells including an n-well 110, a p-well 112 over n-well 110, a p+ well 114 within p-well 112 and a p++ well 116 within p+well 114. P++well 116 provides an anode region 130 of SPAD 102. SPAD 102 may also include n-wells 118 coupling n-well 110 to n+wells 120. N+wells 120 provide a cathode region 132 of SPAD 102. Each of the wells within substrate 104 may be formed by any now known or later developed doping technology, e.g., by ion implantation or in-situ doping. Wells 112, 114, 116, 120 may share an upper surface with that of substrate 104. N-wells 110 and 118 have the opposite doping type from substrate 104, e.g., they may be lightly doped N-type (known as "n- doping") in the case where substrate 104 is doped p-type. N+wells 120 have higher n-type doping concentrations than n-wells 110, 118. P+well 114 has a higher p-type doping concentration than substrate 104, and p++ well 116 has a higher p-type doping concentration than p+well 114 and substrate 104. Wells 110, 112, 114, 116, 118 and 120 thus may be distinguished from substrate 104 at least partially based on doping concentration, dopant types and/or materials, etc.

As noted, SPAD 102 may include anode region 130 and cathode region 132. A distance separates anode region 130 from cathode region 132 and ensures that an avalanche junction will form within the depletion region that n-well 110 defines. As described herein, anode region 130 may be a region of semiconductor material within n-well 110 that has an opposite polarity from n-well 110, e.g., it may be more highly doped p-type ("p++ doping") to create a strong P-N junction between anode region 130 and n-well 110 thereunder. Cathode region 132 may be of the same doping type as n-well 110, but with a higher doping concentration. For instance, cathode region 132 may have "n+" doping in the case where n-well 110 has "n-" doping. Incoming light L to anode region 130 may produce a current pathway within structure 100.

SPAD 102 in structure 100 operates via the same principle as other diode junctions in an integrated circuit. That is, anode region 130 and cathode region 132 provide two oppositely doped regions which allow current to flow easily from anode region 130 to cathode region 132 but resist current flow in the opposite direction. SPADs in particular are structured to operate at higher voltages than other types of diodes. In an ordinary diode, voltage and structural breakdown will occur when the voltage applied thereto exceeds an inherent peak voltage for the diode. SPADs, however, may continue to operate beyond their breakdown voltage by having an avalanche junction formed therein. N-well 110 functions as the wider depletion region between anode region 130 and cathode region 132, enabling these portions of structure 100 to exhibit "avalanche breakdown" above its breakdown voltage. An incoming photon to anode region 130 thus will impart sufficient energy to induce a current from anode region 130 to cathode region 132, enabling the regions to detect incoming light.

While a particular arrangement of doped wells is illustrated, SPAD 102 may include any now known or later developed SPAD photodetector. For example, in other implementations cathode region 132 may be at the center of anode region 130. In certain embodiments, SPAD 102 may constitute a front side illuminated SPAD (FSI SPAD) photodetector. "Front side illuminated" indicates light L, e.g., visible light, sensed by the FSI SPAD enters through a top layer of the structure, e.g., chip. Light L is illustrated by dashed arrows in FIG. 1 and enters structure 100 from the top of the page. Although light L is illustrated as passing through and illuminating the upper (i.e., "front") side of structure 100, in some cases, light traveling from the bottom (i.e., "back") side of structure 100 (not shown) also may produce an electric current. Collectively, at least anode region 130, n-well 110 and cathode region 132 define SPAD 102 within structure 100. Hereafter, SPAD 102 will collectively indicate a SPAD or the more particular FSI SPAD photodetector. Structure 100 may include any number of SPADs 102, e.g., arranged side-by-side or in an array, to detect light L.

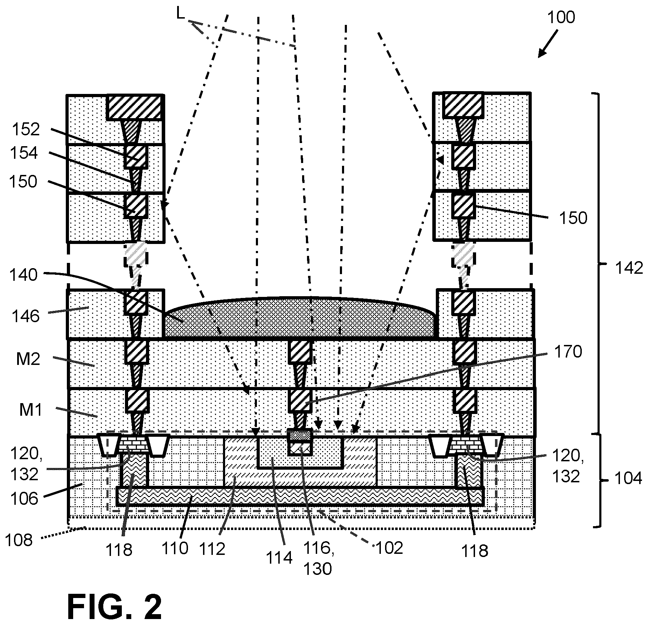

Structure 100 may also include at least one dome-shaped lens 140 over each SPAD 102. Each dome-shaped lens 140 along with a metal guard ring 150, described herein, act to direct light L in a more focused manner toward anode region 130 to improve light absorption. In the embodiment shown in FIG. 1, a plurality of dome-shaped lenses 140 are used over each SPAD 102. In another example, shown in the cross-sectional view of FIG. 2, a single dome-shaped lens 140 may be used. Any number of dome-shaped lens(es) 140 may be employed.

The dome-shaped lens(es) 140 can be located at any back-end-of-line (BEOL) interconnect layer 142 over SPAD 102. Dome-shaped lens(es) 140 may include, for example, an oxide or a nitride. In FIG. 1, dome-shaped lens(es) 140 are located over a last BEOL interconnect layer 144, and in FIG. 2, dome-shaped lens 140 is in a third metal/via layer 146 over SPAD 102 and, in particular, anode region 130. While shown in both a metal and via layer, dome-shaped lens(es) 140 can be in one or the other layer. As used herein, "dome-shaped" indicates lens(es) 140 have a rounded upper surface. The radius of the rounded upper surface may vary depending on, for example, the patterning parameters used to form the lens(es) 140, e.g., etching parameters; number of lens(es) 140; and/or the dimensions of the space in which lens(es) 140 are used.

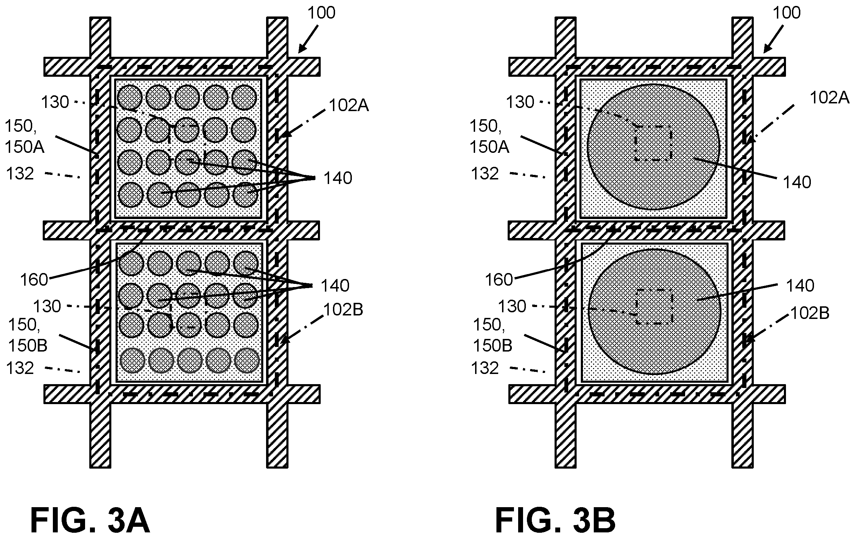

FIGS. 3A-B show schematic top-down views of structure 100 along an illustrative view line A-A in FIG. 1 according to various embodiments. Structure 100 includes dome-shaped lens(es) 140, SPAD 102 and metal guard ring 150. As shown, in certain embodiments, structure 100 may include a first SPAD 102A adjacent a second SPAD 102B. In certain embodiments, as shown in FIG. 3A, where more than one lens 140 is used, they may be arranged in, for example, an array of aligned columns and rows. The columns and rows are shown vertically and/or horizontally on the page, but it is recognized that they are in a plane in the final product. Any number of columns and rows may be used. In other embodiments, as shown in FIG. 3B, where a single lens 140 is used, it may be centered over SPAD 102 and/or within metal guard ring 150.

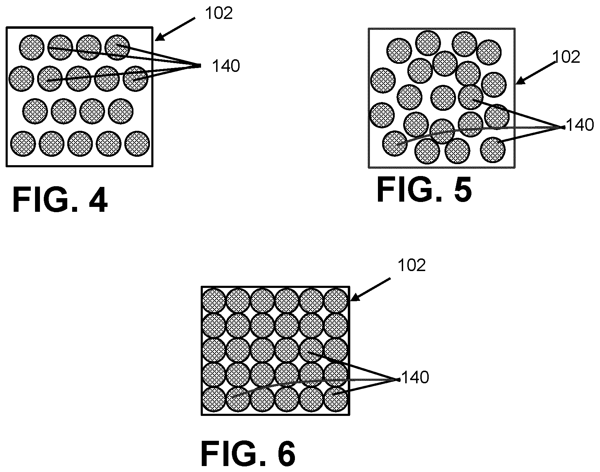

As shown in the partial top-down views of FIGS. 4 and 5 of dome-shaped lens(es) 140 over a SPAD 102, lens(es) 140 can alternatively be arranged in staggered columns and rows (FIG. 4), or arranged in a shaped pattern such as but not limited to circular, concentric circulars (shown), ovals, crosses, etc. (FIG. 5). Lens(es) 140 may be spaced from one another, as shown in FIGS. 3-5, or they may abut one another as shown in the partial top-down view of FIG. 6. It will be recognized that lens(es) 140 can be arranged in a wide variety of alternative ways to focus light L on SPAD 102 and, in particular, anode region 130 thereof, depending on but not limited to: the size of SPAD(s) 102, the configuration and/or location of anode region 130 therein, and the areal space within a metal guard ring 150.

As shown in FIGS. 1-3, structure 100 may also include a metal guard ring 150 surrounding each SPAD 102. In certain embodiments, as noted relative to FIGS. 3A-B, the at least one SPAD 102 may include first SPAD 102A adjacent second SPAD 102B with each of first and second SPADs 102A, 102B including the at least one dome-shaped lens 140 thereover. That is, FIGS. 3A-B shows structure 100 including first SPAD 102A adjacent second SPAD 102B, and each SPAD 102A, 102B includes dome-shaped lens(es) 140 thereover. Although SPADs 102A, 102B are shown with identical arrangements of dome-shaped lenses 140, they can be arranged in different ways for each SPAD 102. While FIG. 3A shows a plurality of lenses 140, FIG. 3B shows a single domed-shaped lens 140, as in FIG. 2, may be used.

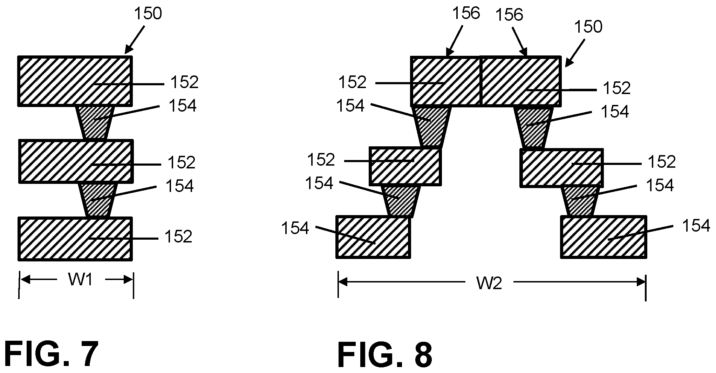

As illustrated in FIGS. 3A-B, a metal guard ring 150 surrounds each SPAD 102A, 102B. As shown in FIGS. 1-2, metal guard ring 150 includes a plurality of vertically stacked wires 152 and vias 154 in any number of BEOL interconnect layers 142. Metal guard ring 150 can take a variety of forms. FIGS. 7 and 8 show cross-sectional views of two different arrangements of metal guard ring 150. In FIGS. 1, 2 and 7, metal guard ring 150 includes a single wall of vertically stacked metal wires 152 and vias 154. In this arrangement, a maximum width of, for example, metal wires 152 thereof may be approximately 0.2 micrometers. FIG. 8 shows another option in which metal guard ring 150 includes a pair of vertically stacked and staggered rows 156 of wires 152 and vias 154 forming, for example, an inverted V-shaped cross-section. In this arrangement, a maximum width W2 of, for example, the farthest apart metal wires 152 thereof may be between approximately 2 and 8 micrometers. Other arrangements of metal guard ring 150 may also be used.

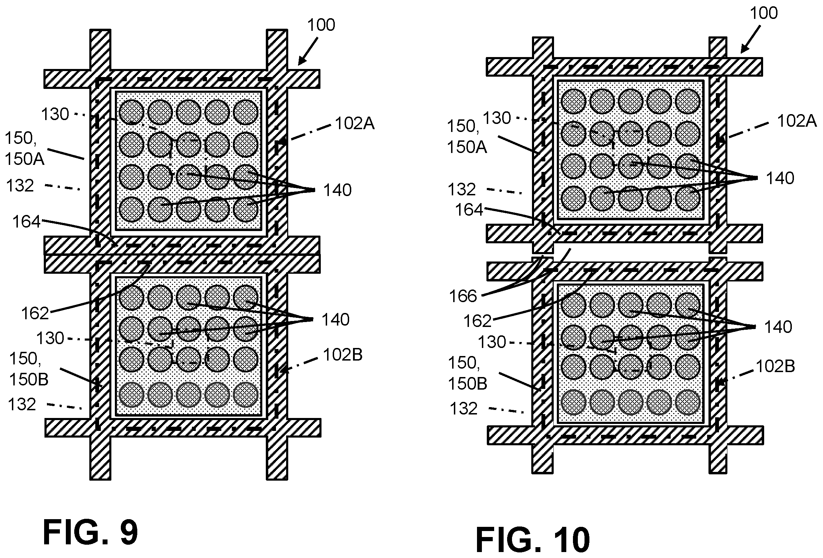

Metal guard ring 150 can have a wide variety of lateral arrangements around SPAD(s) 102. In FIGS. 3A-B, metal guard ring 150A surrounding first SPAD 102A shares a wall portion 160 thereof with metal guard ring 150B surrounding second, adjacent SPAD 102B. That is, metal guard rings 150A and 150B share wall portion 160. FIG. 9 shows a schematic top-down view of structure 100 along illustrative view line A-A in FIG. 1 including dome-shaped lens(es) 140, SPADs 102A-B and metal guard rings 150A-B, according to other embodiments. In FIG. 9, structure 100 includes first SPAD 102A adjacent second SPAD 102B. In this case, however, metal guard ring 150A surrounding first SPAD 102A abuts metal guard ring 150B surrounding second SPAD 102B, e.g., along adjacent portions 162, 164 thereof. FIG. 10 shows a schematic top-down view of structure 100 along illustrative view line A-A in FIG. 1 including dome-shaped lens(es) 140, SPADs 102 and metal guard rings 150A-B, according to additional embodiments. In FIG. 10, structure 100 includes first SPAD 102A adjacent second SPAD 102B. Here, metal guard ring 150A surrounding first SPAD 102A is spaced from metal guard ring 150B surrounding second SPAD 102B by a dielectric 166, i.e., a dielectric of BEOL interconnect layer(s) 142. Other arrangements of adjacent or interconnected metal guard rings 150 are also possible.

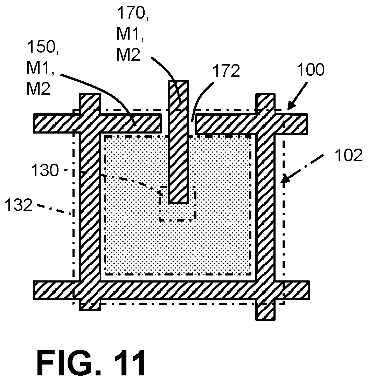

FIG. 11 shows a schematic top-down view of structure 100 along illustrative view line B-B in FIG. 1 without dome-shaped lens(es) 140 shown but showing SPAD 102 and metal guard ring 150 therefor, according to other embodiments. As shown in FIGS. 1, 2 and 11, metal guard ring 150 is positioned within a plurality of interconnect layers 142 extending above SPAD 102. Structure 100 may further include an electrical connection 170 to SPAD 102. As shown in FIG. 11, electrical connection 170 extends through an opening 172 in metal guard ring 150 to SPAD 102 in at least one of plurality of interconnect layers 142, e.g., first and second metal layers M1 and M2, adjacent to SPAD 102. Electrical connection 170 may include any number of wires and/or vias extending through opening 172. In the example shown, electrical connection 170 is located in both first and second metal layers M1, M2; however, it could be located in just first metal layer M1.

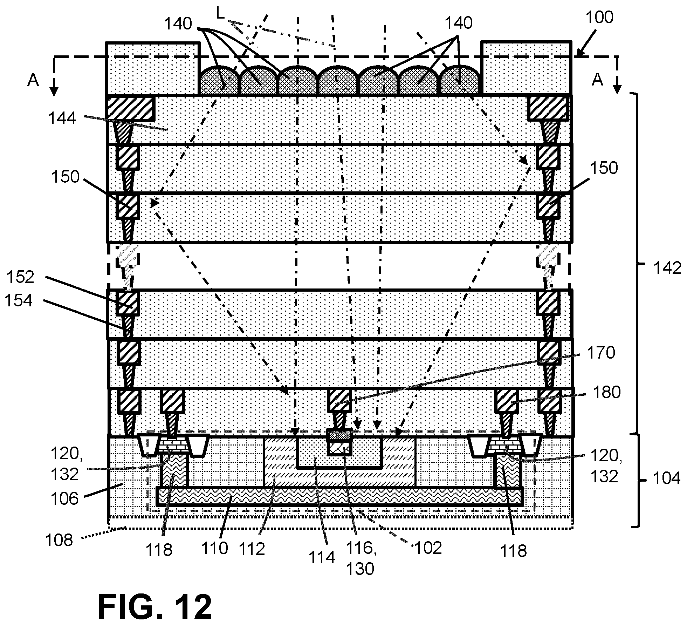

In FIGS. 1 and 2, metal guard ring 150 is shown electrically connected to cathode region 132. In this case, electrical communication with cathode region 132 can be made through metal guard ring 150, i.e., through one or more metal and/or via layers thereof. In other embodiments, as shown in the cross-sectional view of FIG. 12, metal guard ring 150 may not be connected to cathode region 132. In this case, one or more additional electrical connections 180, similar to electrical connection 170, may be separately made to cathode region 132. Electrical connections 180 may exit metal guard ring 150 through opening 172 (FIG. 11).

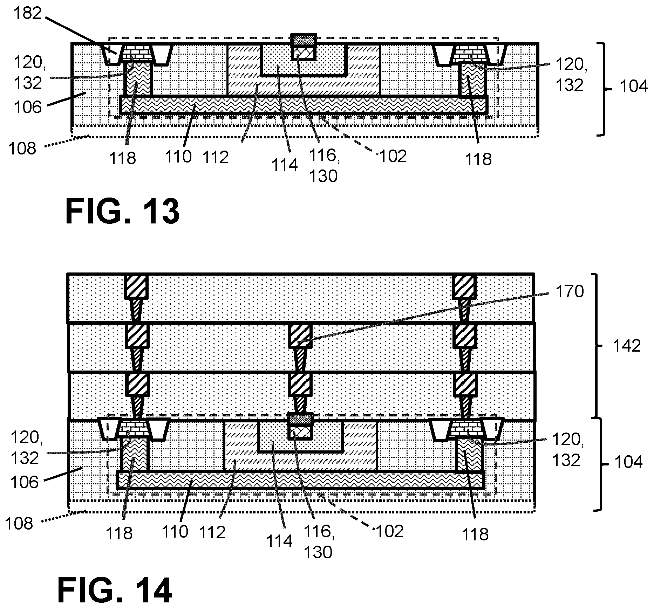

FIGS. 13-17 show cross-sectional views of a method according to embodiments of the disclosure. The method may form structure 100. FIG. 13 shows forming at least one SPAD 102 in substrate 104. SPAD 102 may be formed, as described herein, using any now known or later developed doping techniques such as but not limited to ion implantation and in-situ doping. Any variety of trench isolation 182 configuration, i.e., dielectric filled trench(es), may be formed in substrate 104 to isolate parts of SPAD 102.

FIG. 14 shows a cross-sectional view of forming metal guard ring 150 surrounding each SPAD 102. Metal guard ring 150 may be formed using any now known or later developed BEOL interconnect technology. More particularly, metal guard ring 150 may be formed within a plurality of BEOL interconnect layers 142 extending above SPAD 102 and, as shown in FIG. 12, with electrical connection 170 extending through opening 172 in metal guard ring 150 to SPAD 102 in at least one of the plurality of interconnect layers, e.g., M1 and/or M2, adjacent to SPAD 102. Metal wires and vias of metal guard ring 150 may be formed by, for example, depositing a dielectric layer (e.g., any interlayer dielectric (ILD) material such oxide and/or nitride) patterning a mask (not shown), etching the dielectric layer using the mask to form openings therein, depositing a conductor, planarizing to remove excess conductor, and repeating the process until the desired height of metal guard ring 150 is generated. The conductor(s) used may include any appropriate conductor material for the metal wire and/or via at the given BEOL interconnect layer 142, such as but not limited to copper, aluminum, tungsten, etc., within a refractory metal liner. The metal wires and vias may be made together, i.e., using dual Damascene processing, or separately, i.e., using single Damascene processing. Metal guard ring 150 may be formed in as many BEOL interconnect layers 142 as desired, but typically extends through most, if not all, BEOL interconnect layers 142 to ensure light L is focused towards SPAD 102, as described herein.

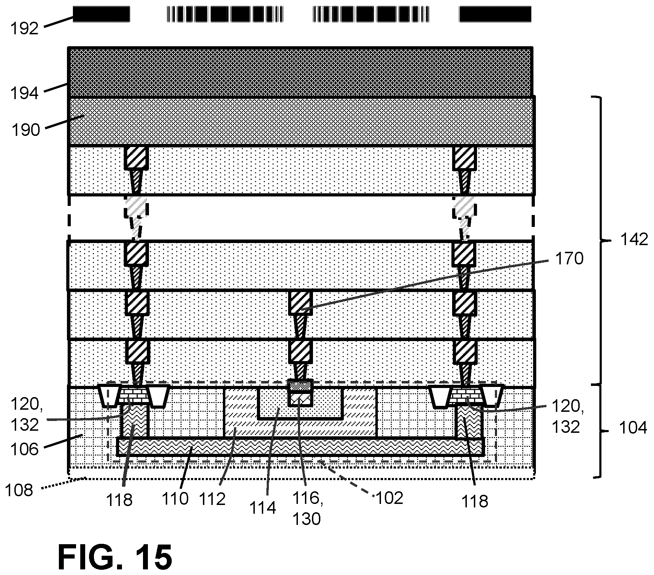

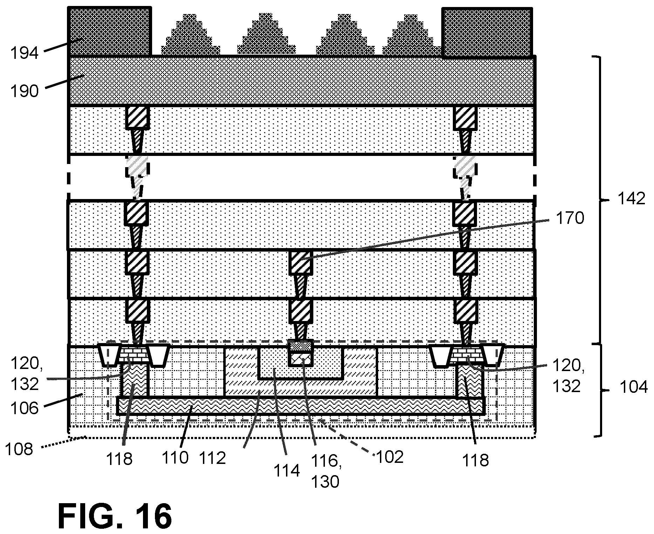

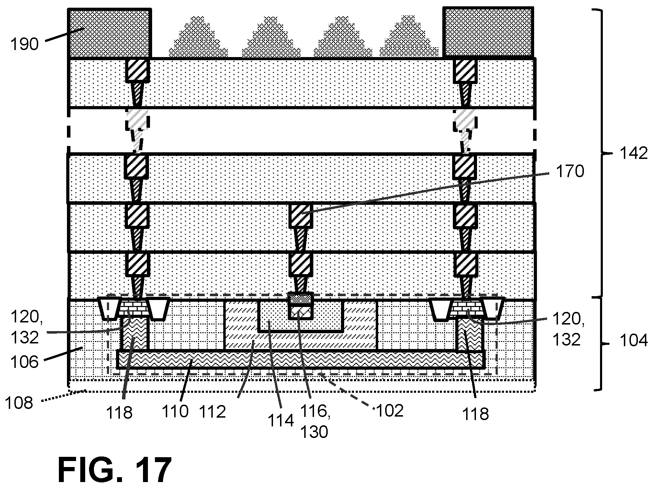

FIGS. 1, 2, 12 and 15-17 show cross-sectional views of forming at least one dome-shaped lens 140 over each SPAD 102. Dome-shaped lens(es) 140 can be formed at any given BEOL interconnect layer 142. As shown in FIG. 15, forming dome-shaped lens(es) 140 may include forming adielectric layer 190 over each SPAD 102 and performing a grayscale lithography process on dielectric layer 190. Dielectric layer 190 may include, for example, an oxide or a nitride. The grayscale lithography processes include using gray values to create 2.5 dimensional (2.5D) surface profiles using a single exposure. The process includes, as shown in FIG. 15, using an optical gray-scale mask 192 with different intensities of gray pixels and different spacing, modulating the intensity of the laser on a pixel-by-pixel level over a photoresist 194 on dielectric layer 190. As shown in FIG. 16, the process includes stripping the exposed photoresist 194 by developing it. As shown in FIG. 17, the remaining three-dimensional outline on photoresist 194 surface can then be transferred to dielectric layer 190 to create dome-shaped lens(es) 140, e.g., by etching dielectric layer 190 to form dome-shaped lens(es) 140 using an appropriate dry etch chemistry such as but not limited to a reactive ion etch. A wet etch may then be used to round upper surface(s) and finalize dome-shaped lens(es) 140 as shown in FIGS. 1-2 and 12. (Note, the shading of dome-shaped lens(es) 140 is different than the ILD of the BEOL interconnect layer 142 in which located for purposes of contrast in illustration; it is recognized, the materials may be the same, e.g., oxide or nitride,). It will be recognized that where metal guard ring 150 extends in the same layer as dome-shaped lens(es) 140, e.g., as in FIG. 2, one or more additional layers of metal guard ring 150 can then be formed in dielectric layer 190 alongside dome-shaped lens(es) 140 and perhaps in additional BEOL interconnect layers 142 thereover.

Embodiments of the disclosure provide various technical and commercial advantages, examples of which are discussed herein. The dome-shaped lens(es) with the metal guard ring improve SPAD efficiency in terms of photo detection probability (PDP) and light absorption with minimal increase in areal size. Mor particularly, the dome-shaped lens(es) and metal guard ring confine more light, resulting in a higher intensity and more distributed light reaching the SPAD.

The structure and method as described above are used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about", "approximately" and "substantially", are not to be limited to the precise value specified. **In** at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/-10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description, but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

The following embodiments are explicitly disclosed.

### Embodiment 1:

A structure, comprising:
at least one single-photon avalanche diode (SPAD) in a substrate;
at least one dome-shaped lens over each SPAD; and
a metal guard ring surrounding each SPAD.

### Embodiment 2:

The structure of embodiment 1, wherein the SPAD is a front-side illuminated SPAD.

### Embodiment 3:

The structure of embodiment 1 or 2, wherein the at least one dome-shaped lens includes a plurality of dome-shaped lenses over each SPAD.

### Embodiment 4:

The structure of one of embodiments 1 to 3, wherein the metal guard ring includes a plurality of vertically stacked wires and vias.

### Embodiment 5:

The structure of one of embodiments 1 to 4, wherein the metal guard ring includes a pair of vertically stacked and staggered rows of wires and vias.

### Embodiment 6:

The structure of one of embodiments 1 to 5, wherein the metal guard ring is positioned within a plurality of interconnect layers extending above the SPAD, and further comprising an electrical connection extending through an opening in the metal guard ring to the SPAD in at least one of the plurality of interconnect layers adjacent to the SPAD.

### Embodiment 7:

The structure of one of embodiments 1 to 6, wherein the at least one SPAD includes a first SPAD adjacent a second SPAD with each of the first and second SPADs including the at least one dome-shaped lens thereover, and wherein the metal guard ring surrounding the first SPAD abuts the metal guard ring surrounding the second SPAD.

### Embodiment 8:

The structure of one of embodiments 1 to 7, wherein the at least one SPAD includes a first SPAD adjacent a second SPAD with each of the first and second SPADs including the at least one dome-shaped lens thereover, and wherein the metal guard ring surrounding the first SPAD shares a portion thereof with the metal guard ring surrounding the second SPAD.

### Embodiment 9:

The structure of one of embodiments 1 to 8, wherein the at least one SPAD includes a first SPAD adjacent a second SPAD with each of the first and second SPADs including the at least one dome-shaped lens thereover, and wherein the metal guard ring surrounding the first SPAD is spaced from the metal guard ring surrounding the second SPAD by a dielectric.

### Embodiment 10:

A front-side illuminated single-photon avalanche diode (FSI SPAD) photodetector, comprising:
at least one FSI SPAD in a substrate;
at least one dome-shaped lens over each FSI SPAD; and
a metal guard ring surrounding each FSI SPAD.

In some illustrative examples herein, the embodiment 10 may provide a front-side illuminated single-photon avalanche diode (FSI SPAD) photodetector, comprising the structure of one of embodiments 1 to 9, wherein at least one of the at least one SPAD is a front-side illuminated single-photon avalanche diode (FSI SPAD).

### Embodiment 11:

The FSI SPAD photodetector of embodiment 10, wherein the at least one dome-shaped lens includes a plurality of dome-shaped lenses over each SPAD.

### Embodiment 12:

The FSI SPAD photodetector of embodiment 10 or 11, wherein the metal guard ring includes a plurality of vertically stacked wires and vias.

### Embodiment 13:

The FSI SPAD photodetector of one of embodiments 10 to 12, wherein the metal guard ring includes a pair of vertically stacked and staggered rows of wires and vias.

### Embodiment 14:

The FSI SPAD photodetector of one of embodiments 10 to 13, wherein the metal guard ring is positioned within a plurality of interconnect layers extending above the SPAD, and further comprising an electrical connection extending through an opening in the metal guard ring to the SPAD in at least one of the plurality of interconnect layers adjacent to the SPAD.

### Embodiment 15:

The FSI SPAD photodetector of one of embodiments 10 to 14, wherein the at least one SPAD includes a first SPAD adjacent a second SPAD with each of the first and second SPADs including the at least one dome-shaped lens thereover, and wherein the metal guard ring surrounding the first SPAD abuts the metal guard ring surrounding the second SPAD.

### Embodiment 16:

The FSI SPAD photodetector of one of embodiments 10 to 15, wherein the at least one SPAD includes a first SPAD adjacent a second SPAD with each of the first and second SPADs including the at least one dome-shaped lens thereover, and wherein the metal guard ring surrounding the first SPAD shares a portion thereof with the metal guard ring surrounding the second SPAD.

### Embodiment 17:

The FSI SPAD photodetector of one of embodiments 10 to 16, wherein the at least one SPAD includes a first SPAD adjacent a second SPAD with each of the first and second SPADs including the at least one dome-shaped lens thereover, and wherein the metal guard ring surrounding the first SPAD is spaced from the metal guard ring surrounding the second SPAD by a dielectric.

### Embodiment 18:

A method, comprising:
forming at least one single-photon avalanche diode (SPAD) in a substrate;
forming a metal guard ring surrounding each SPAD; and
forming at least one dome-shaped lens over each SPAD.

### Embodiment 19:

The method of embodiment 18, wherein forming the at least one dome-shaped lens includes: forming a dielectric layer over each SPAD, performing a grayscale lithography process on the dielectric layer, and etching the dielectric layer to form the at least one dome-shaped lens.

### Embodiment 20:

The method of embodiment 18 or 19, wherein forming the metal guard ring includes forming the metal guard ring within a plurality of interconnect layers extending above the SPAD and with an electrical connection extending through an opening in the metal guard ring to the SPAD in at least one of the plurality of interconnect layers adjacent to the SPAD.

### Embodiment 21:

The method of one of embodiments 18 to 20, wherein at least one of the structure of one of embodiments 1 to 9 and the FSI SPAD photodetector of one of embodiments 10 to 17 is formed. In summary of the above, a structure is provided, the structure including at least one single-photon avalanche diode (SPAD), at least one dome-shaped lens over each SPAD, and a metal guard ring surrounding each SPAD. A front-side illuminated SPAD photodetector and a method of forming the structure is also provided. The dome-shaped lens(es) with the metal guard ring improve SPAD efficiency in terms of photo detection probability (PDP) and light absorption with minimal increase in area.

## Claims

1. A structure, comprising:
at least one single-photon avalanche diode (SPAD) in a substrate;
at least one dome-shaped lens over each SPAD; and
a metal guard ring surrounding each SPAD.

2. The structure of claim 1, wherein the SPAD is a front-side illuminated SPAD.

3. The structure of claim 1 or 2, wherein the at least one dome-shaped lens includes a plurality of dome-shaped lenses over each SPAD.

4. The structure of one of claims 1 to 3, wherein the metal guard ring includes a plurality of vertically stacked wires and vias.

5. The structure of one of claims 1 to 4, wherein the metal guard ring includes a pair of vertically stacked and staggered rows of wires and vias.

6. The structure of one of claims 1 to 5, wherein the metal guard ring is positioned within a plurality of interconnect layers extending above the SPAD, and further comprising an electrical connection extending through an opening in the metal guard ring to the SPAD in at least one of the plurality of interconnect layers adjacent to the SPAD.

7. The structure of one of claims 1 to 6, wherein the at least one SPAD includes a first SPAD adjacent a second SPAD with each of the first and second SPADs including the at least one dome-shaped lens thereover, and wherein the metal guard ring surrounding the first SPAD abuts the metal guard ring surrounding the second SPAD.

8. The structure of one of claims 1 to 6, wherein the at least one SPAD includes a first SPAD adjacent a second SPAD with each of the first and second SPADs including the at least one dome-shaped lens thereover, and wherein the metal guard ring surrounding the first SPAD shares a portion thereof with the metal guard ring surrounding the second SPAD.

9. The structure of one of claims 1 to 6, wherein the at least one SPAD includes a first SPAD adjacent a second SPAD with each of the first and second SPADs including the at least one dome-shaped lens thereover, and wherein the metal guard ring surrounding the first SPAD is spaced from the metal guard ring surrounding the second SPAD by a dielectric.

10. A front-side illuminated single-photon avalanche diode (FSI SPAD) photodetector, comprising the structure of one of claims 1 to 9, wherein at least one of the at least one SPAD is a front-side illuminated single-photon avalanche diode (FSI SPAD).

11. The FSI SPAD photodetector of claim 10, wherein the at least one dome-shaped lens includes a plurality of dome-shaped lenses over each SPAD.

12. A method, comprising:
forming at least one single-photon avalanche diode (SPAD) in a substrate;
forming a metal guard ring surrounding each SPAD; and
forming at least one dome-shaped lens over each SPAD.

13. The method of claim 12, wherein forming the at least one dome-shaped lens includes:
forming a dielectric layer over each SPAD, performing a grayscale lithography process on the dielectric layer, and etching the dielectric layer to form the at least one dome-shaped lens.

14. The method of claim 12 or 13, wherein forming the metal guard ring includes forming the metal guard ring within a plurality of interconnect layers extending above the SPAD and with an electrical connection extending through an opening in the metal guard ring to the SPAD in at least one of the plurality of interconnect layers adjacent to the SPAD.

15. The method of one of claims 12 to 14, wherein at least one of the structure of one of claims 1 to 9 and the FSI SPAD photodetector of claim 10 or 11 is formed.
